# EUROPEAN PATENT APPLICATION

(11) **EP 1 589 054 A1**
(43) Date of publication of application: **26.10.2005**
(21) Application number: 04706864.8
(22) Date of filing: 30.01.2004
(51) Int. Cl.: C08G 61/00, C08L 65/00

(54) **POLYMERIZABLE COMPOSITION, THERMOPLASTIC RESIN COMPOSITION, CROSSLINKED RESIN, AND CROSSLINKED RESIN COMPOSITE MATERIALS**

(30) Priority: 31.01.2003 JP 2003023566
(71) Applicant: ZEON CORPORATION, Tokyo 100-8323 (JP)
(72) Inventor: SUGAWARA Tomoo, c/o ZEON CORPORATION, Tokyo 1008323 (JP)
(74) Representative: Vossius & Partner
(86) International application number: PCT/JP2004/000902
(87) International publication number: WO 2004/067601

(57) **Abstract**

A polymerizable composition which comprises (i) a cycloolefin monomer, (ii) a metathesis polymerization catalyst, (iii) a chain transfer agent, (iv) a radical crosslinking agent, and (v) a compound (α) selected from the group consisting of compounds having alkoxyphenol structures wherein each aromatic ring has one or more substituents, compounds having aryloxyphenol structures, and compounds having catechol structures wherein each aromatic ring has two or more substituents; a thermoplastic resin composition which comprises (1) a cycloolefin thermoplastic resin, (2) a radical crosslinking agent, and (3) a compound (α) ; a process for the production thereof; a crosslinked resin obtained by crosslinking the thermoplastic resin composition; and crosslinked resin composite materials produced by laminating a substrate with the thermoplastic resin composition and crosslinking the thermoplastic resin composition. The invention provides a polymerizable composition useful as raw material in the production of a thermoplastic resin composition excellent in storage stability and fluidity in heat lamination; a thermoplastic resin composition and a process for the production thereof; a crosslinked resin obtained by crosslinking the thermoplastic resin composition; and crosslinked resin composite materials exhibiting excellent interlayer adhesion.

## Description

### TECHNICAL FIELD

The present invention relates to a polymerizable composition and a thermoplastic resin composition useful as a raw material for the production of a thermoplastic resin composition exhibiting excellent storage stability and fluidity in heat lamination; a process for the production thereof; a crosslinked resin obtained by crosslinking the thermoplastic resin composition; and a crosslinked resin composite material.

### BACKGROUND ART

Conventionally, molded products produced by crosslinking thermoplastic norbomene resins with a crosslinking agent such as organic peroxide have been known. For example, Japanese Patent Application Laid-open No. 6-248164 describes a crosslinked molded product produced by preparing a homogeneously dispersed norbornene resin composition by adding 0.001-30 parts by weight of an organic peroxide to 100 parts by weight of a thermoplastic hydrogenated ring-opening norbornene resin and adding 0.1-10 parts by weight of a crosslinking co-agent to one part by weight of the organic peroxide, forming the composition into a film or prepreg, laminating the film or prepreg, and crosslinking/fusing the resulting laminate by heat-press. The patent specification describes that the crosslinked molded product exhibits excellent heat resistance, solvent resistance, chemical resistance, moisture resistance, water resistance, and electrical properties and is useful as an interlayer dielectric, a film for forming a moisture-proof layer, and the like. However, the method described in this document achieves only insufficient interlayer adhesion due to the crosslinking reaction at an early stage of the heat-press molding process, which results in loss of fluidity.

National Publication of Translation No. 11-507962 discloses a method which comprises polymerizing cycloolefins such as a norbomene monomer in the presence of a ruthenium-carbene complex and a crosslinking agent by metathesis polymerization to produce a polycycloolefin and post-curing (post-crosslinking) the polymer. However, the norbomene resin before post-cure does not have thermoplasticity. The inventors of the present invention confirmed that heat-press lamination of the norbornene resin with a copper foil does not cause the resin before post-cure to melt, but causes only the cross-linking reaction to proceed. For this reason, it is difficult to produce a copper-clad laminate with excellent interlayer adhesion.

Japanese Patent Application Laid-open No. 2002-137233 discloses a molding method which comprises preparing a first solution by adding a polymerization modifier, an organic peroxide, and an antioxidant such as a unsubstituted alkoxy phenol or a mono-substituted catechol to a cycloolefin compound and a secondary solution containing a metathesis polymerization catalyst, mixing the two solutions, charging the mixture to a mold, and curing the mixture. However, the method described in this document achieves only insufficient interlayer adhesion.

### DISCLOSURE OF THE INVENTION

The present invention has been completed in view of this situation. Specifically, an object of the present invention is to provide a polymerizable composition and a thermoplastic resin composition useful as a raw material for the production of a thermoplastic resin composition having excellent in storage stability and fluidity in heat lamination; a process for the production thereof; a crosslinked resin obtained by crosslinking the thermoplastic resin composition; and a crosslinked resin composite material exhibiting excellent interlayer adhesion.

The present inventors have conducted extensive studies to achieve the above objects. As a result, the inventors of the present invention have found that (a) if a polymerizable composition containing a cycloolefin, monomer, a chain transfer agent, a radical crosslinking agent, and a retarder for crosslinking is polymerized in the presence of a metathesis polymerization catalyst, a thermoplastic resin composition excelling in fluidity during heat-lamination and exhibiting a high conversion ratio of polymerization reaction, with a minimal crosslinking reaction, can be efficiently obtained, (b) the resulting thermoplastic resin composition containing a radical crosslinking agent and a specific radical crosslinking agent excels in storage stability and, if heated to a prescribed temperature to cause the crosslinking reaction to occur, efficiently produces a crosslinked resin, and (c) if this thermoplastic resin composition is layered with other materials such as a metallic foil and a substrate, and heated and crosslinked at a prescribed temperature, a crosslinked resin composite material excelling in adhesion with other materials can be efficiently obtained. These findings have led to the completion of the present invention.

Specifically, the present invention provides a polymerizable composition which comprises (i) a cycloolefin monomer, (ii) a metathesis polymerization catalyst, (iii) a chain transfer agent, (iv) a radical crosslinking agent, and (v) a compound (α) selected from the group consisting of compounds having an alkoxyphenol structure with one or more substituents on the aromatic ring, compounds having an aryloxyphenol structure, and compounds having a catechol structure with two or more substituents on the aromatic ring.

In the polymerizable composition of the present invention, the compound (α) is preferably a retarder for radical crosslinking or a compound having an alkoxyphenol structure with one or more substituents on the aromatic ring.

The polymerizable composition of the present invention preferably contains the radical crosslinking agent in an amount of 0.1-10 parts by weight per 100 parts by weight of the cycloolefin monomer and the compound (α) in an amount of 0.001-1 mol per one mol of the radical crosslinking agent.

The present invention further provides a thermoplastic resin composition comprising (1) a cycloolefin thermoplastic resin, (2) a radical crosslinking agent, and (3) a compound (α) selected from the group consisting of compounds having an alkoxyphenol structure with one or more substituents on the aromatic ring, compounds having an aryloxyphenol structure, and compounds having a catechol structure with two or more substituents on the aromatic ring.

In the thermoplastic resin composition of the present invention, the compound (α) is preferably a retarder for radical crosslinking or a compound having an alkoxyphenol structure with one or more substituents on the aromatic ring.

The thermoplastic resin composition of the present invention preferably contains the radical crosslinking agent in an amount of 0.1-10 parts by weight per 100 parts by weight of the cycloolefin thermoplastic resin and the compound (α) in an amount of 0.001-1 mol per one mol of the radical crosslinking agent.

The thermoplastic resin composition of the present invention is preferably in the form of a film or impregnated in a fiber material.

The present invention further provides a process for manufacturing the above thermoplastic resin composition, which comprises a step of polymerizing the polymerizable composition of the present invention by bulk polymerization.

In the process of the present invention, the bulk polymerization is carried out at a temperature equivalent to or lower than the one-minute half-life temperature of the radical crosslinking agent.

The process of the present invention preferably has a step of polymerizing the polymerizable composition of the present invention by bulk polymerization on a supporting body and molding the polymer into the form of a film.

In the above process of the present invention, the supporting body is preferably a resin film or a metallic foil.

The present invention further provides a crosslinked resin prepared by crosslinking the thermoplastic resin composition of the present invention.

The present invention further provides a process for manufacturing a crosslinked resin comprising a step of crosslinking the thermoplastic resin composition of the present invention by heating to melt at a temperature of 150-250°C.

The present invention still further provides a crosslinked resin composite material prepared by laminating the thermoplastic resin composition on a substrate and crosslinking the thermoplastic resin composition.

In the crosslinked resin composite material of the present invention, the substrate is preferably a metallic foil or a printed-wiring board.

### BEST MODE FOR CARRYING OUT THE INVENTION

The present invention will be described in detail below.

### 1) Polymerizable composition

The polymerizable composition of the present invention comprises (i) a cycloolefin monomer, (ii) a metathesis polymerization catalyst, (iii) a chain transfer agent, (iv) a radical crosslinking agent, and (v) a compound (α) selected from the group consisting of compounds having an alkoxyphenol structure with one or more substituents on the aromatic ring, compounds having an aryloxyphenol structure, and compounds having a catechol structure with two or more substituents on the aromatic ring.

### (i) Cycloolefin monomer

As the cycloolefin monomer used in the present invention, a monocycloolefin monomer, a norbomene monomer, and the like can be given. These cycloolefin monomers may be used either individually or in combination of two or more. When two or more cycloolefin monomers are used, it is possible to control the glass transition temperature and melt temperature of the resulting resin by changing the mixing ratio.

The cycloolefin monomer may be substituted with a hydrocarbon group such as an alkyl group, alkenyl group, alkylidene group, or aryl group, or a polar group such as carboxyl group, alkoxycarbonyl group, hydroxyl group, or alkoxyl group.

As the monocycloolefin monomer, a cyclic monoolefin or cyclic diolefin having usually 4-20, and preferably 4-10 carbon atoms can be given. Specific examples of the cyclic monoolefin include cyclobutene, cyclopentene, methylcyclopentene, cyclohexene, methylcyclohexene, cycloheptene, and cyclooctene. Specific examples of the cyclic diolefin include cyclohexadiene, methylcyclohexadiene, cyclooctadiene, methylcyclooctadiene, and phenylcyclooctadiene.

As the norbomene monomer, substituted or unsubstituted, bicyclic, tricyclic, or polycyclic norbornenes can be given.

As specific examples of the norbomene monomers, bicyclic norbomenes which may possess a functional group such as norbomene, norbornadiene, methyl norbomene, dimethyl norbomene, ethyl norbomene, chlorine substituted norbomene, ethylidene norbornene, chloromethyl norbomene, trimethylsilyl norbornene, phenyl norbomene, cyano norbomene, dicyano norbomene, methoxycarbonyl norbornene, pyridyl norbornene, nadic anhydride, and nadic acid imide; tricyclic norbornenes such as dicyclopentadiene or dihydrodicyclopentadiene, as well as derivatives of these compounds substituted with an alkyl group, alkenyl group, alkylidene group, aryl group, hydroxyl group, acid-anhydride group, carboxyl group, alkoxycarbonyl group, or the like; tetracyclic norbomenes such as dimethanohexahydronaphthalene, dimethanooctahydronaphthalene, as well as derivatives of these compounds substituted with an alkyl group, alkenyl group, alkylidene group, aryl group, hydroxyl group, acid-anhydride group, carboxyl group, alkoxycarbonyl group, or the like; pentacyclic norbomenes such as tricyclopentadiene; hexacyclic norbomenes such as hexacycloheptadecene; other norbomene ring-containing compounds such as dinorbomene, compounds derived from bonding of two norbomenes via a hydrocarbon or an ester group, alkyl or aryl substituted derivatives of these compounds; and the like can be given.

Of these, norbomene-based monomers (referred to as "norbomene monomers" in the present specification) are preferable in the present invention. A compound having a double bond other than the double bond of the norbomene ring can also be used as a norbomene monomer.

The amount of norbomene monomers is preferably 60 wt% or more and more preferably 80 wt% or more of the total amount of cycloolefin monomers.

### (ii) Metathesis polymerization catalyst

There are no specific limitations to the metathesis polymerization catalyst used in the present invention inasmuch as the catalyst can polymerize the cycloolefin monomers by metathesis ring-opening polymerization. For example, ring-opening metathesis reaction catalysts described in Olefin Metathesis and Metathesis Polymerization (K.J. Ivin and J.C. Mol, Academic Press, San Diego, 1997) may be used.

As a specific example of the metathesis polymerization catalyst that can be used, a complex formed from a plurality of ions, atoms, polyatomic ions and/or compounds bonded to a transition metal atom as the center atom can be given. As the transition metal atom, the atoms of groups V, VI, and VIII (in a long periodic-type periodic table, hereinafter the same) can be used. Although there are no specific limitations to the atoms belonging to each group, examples include tantalum as the group V atom, molybdenum and tungsten as the group VI atom, and ruthenium and osmium as the group VIII atom.

Of these, ruthenium and osmium of the group VIII metal are preferable as the complex for the metathesis polymerization catalyst, with a ruthenium-carbene complex being particularly preferred. Due to excellent catalyst activity in bulk polymerization, the ruthenium-carbene complex exhibits excellent productivity in the production of a post-crosslinkable thermoplastic resin. The resultant thermoplastic resin has almost no unfavorable odor (originating from unreacted cycloolefins). In addition, since the catalyst is comparatively stable and is not easily deactivated in oxygen or moisture in the air, the thermoplastic resin can be manufactured under atmospheric conditions using the catalyst.

The ruthenium-carbene complex is a compound represented by the following formulas (1) or (2). 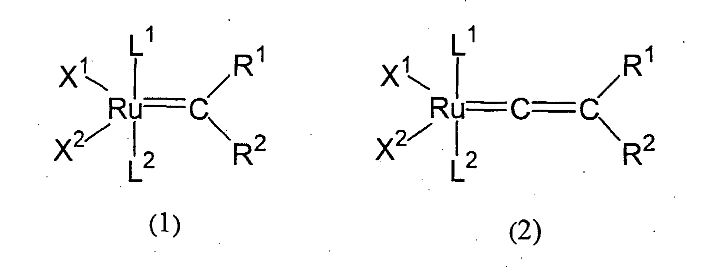 wherein R¹ and R² individually represent a hydrogen atom, a halogen atom, or a hydrocarbon group having 1-20 carbon atoms which may contain a halogen atom, oxygen atom, nitrogen atom, sulfur atom, phosphorus atom, or silicon atom. X¹ and X² individually represent an anionic ligand. L¹ and L² individually represent a hetero atom-containing carbene compound or a neutral electron-donor compound. R¹, R², X¹, X², L¹, and L² groups may bond together in any optional combination to form a multidentate chelated ligand.

Specific examples of the hetero atom include N, O, P, S, As, and Se. Of these, N, O, P, S, and the like are preferable, and N is particularly preferable, because a stable carbene compound can be obtained.

A hetero atom-containing carbene compound having hetero atoms bonding to both sides of the carbene carbon atom is preferable, with a carbene compound having a hetero ring which includes a carbene carbon atom and hetero atoms on both sides of the carbon atom being more preferable. It is desirable that hetero atoms adjacent to the carbene carbon atom have a bulky substituent.

In the above formulas (1) and (2), the anionic ligands X¹ and X² are ligands taking a negative charge when separated from the central metal. Examples of the ligands include halogen atoms such as a fluorine atom, chlorine atom, bromine atom, and iodine atom; a diketonate group, substituted cyclopentadienyl group, alkoxy group, aryloxy group, and carboxyl group. Of these, halogen atoms are preferable, and a chlorine atom is more preferable.

A neutral electron-donor compound may be any ligand taking a neutral charge when separated from the central metal. Specific examples include carbonyls, amines, pyridines, ethers, nitriles, esters, phosphines, thioethers, aromatic compounds, olefins, isocyanides, and thiocyanates. Of these, phosphines, ethers, and pyridines are preferable, and trialkylphosphine is more preferable.

Examples of the complex compound of the formula (1) include ruthenium complex compounds obtainable by bonding of a hetero atom-containing carbene compound and a neutral electron-donor compound such as benzylidene(1,3-dimesitylimidazolidin-2-ylidene)(tricyclohexylphosphine)ruthenium dichloride, (1,3-dimesitylimidazolidin-2-ylidene)(3-methyl-2-buten-1-ylidene) (tricyclopentylphosphine)ruthenium dichloride, benzylidene(1,3-dimesityl-octahydrobenzimidazol-2-ylidene)(tricyclohexylphosphine) ruthenium dichloride, (1,3-dimesitylimidazolidin-2-ylidene)(2-phenylethylidene)(tricyclohexylphosphine) ruthenium dichloride, and (1,3-dimesityl-4-imidazolidin-2-ylidene)(2-phenylethylidene)(tricyclohexylphosphine) ruthenium dichloride; ruthenium compounds in which two neutral electron-donor compounds are bonded such as benzylidenebis(tricyclohexylphosphine)ruthenium dichloride and (3-methyl-2-buten-1-ylidene)bis(tricyclopentylphosphine)ruthenium dichloride; and ruthenium complex compounds in which two hetero atom-containing carbene compounds are bonded such as benzylidenebis(1,3-dicyclohexylimidazolidin-2-ylidene)ruthenium dichloride and benzylidenebis(1,3-diisopropyl-4-imidazolin-2-ylidene)ruthenium dichloride.

Examples of the complex compound of the formula (2) include (1,3-dimesitylimidazolidin-2-ylidene)(phenylvinylidene)(tricyclohexylphosphine) ruthenium dichloride, (t-butylvinylidene)(1,3-diisopropyl-4-imidazolin-2-ylidene)(tricyclopentylphosphine) ruthenium-dichloride, and bis(1,3-dicyclohexyl-4-imidazolin-2-ylidene)phenylvinylideneruthenium dichloride.

These ruthenium complex catalysts can be produced by the methods described in Org. Lett., 1999, Vol. 1, p. 953 and Tetrahedron Lett., 1999, Vol. 40, p. 2247, for example.

The metathesis polymerization catalyst is used at a molar ratio of the metal atoms in the catalyst to the cycloolefins of 1:2,000 to 1:2,000,000, preferably 1:5,000 to 1:1,000,000, and more preferably 1:10,000 to 1:500,000.

An activator (co-catalyst) may be used in combination with the metathesis polymerization catalyst to control the polymerization activity or to increase the conversion ratio of the polymerization reaction. As the activator, an alkyl compound, a halide, an alkoxy compound, an aryloxy compound, and the like of aluminum, scandium, tin, titanium, or zirconium can be given.

Specific examples of the activator include trialkoxy aluminum, triphenoxy aluminum, dialkoxyalkyl aluminum, alkoxydialkyl aluminum, trialkyl aluminum, dialkoxy aluminum chloride, alkoxyalkyl aluminum chloride, dialkyl aluminum chloride, trialkoxy scandium, tetraalkoxy titanium, tetraalkoxy tin, and tetraalkoxy zirconium.

The activator is used at a molar ratio of the metal atoms in the metathesis polymerization catalyst to the activator of 1:0.05 to 1:100, preferably 1:0.2 to 1:20, and more preferably 1:0.5 to 1:10.

When the complex of a transition metal atom of Group V or Group VI is used as a metathesis polymerization catalyst, it is desirable that both the metathesis polymerization catalyst and the activator are dissolved in the monomers. However, it is possible to dissolve or suspend the metathesis polymerization catalyst and activator in a small amount of solvent to the extent that properties of the resulting products are not impaired in substance.

### (iii) Chain transfer agent

In the present invention, a chain transfer agent is used as a component of the polymerizable composition. A thermoplastic resin can be obtained by polymerizing the polymerizable composition containing a chain transfer agent.

As the chain transfer agent, an acyclic olefin which may have a substituent, for example, can be used. As specific examples, aliphatic olefins such as 1-hexene and 2-hexene; aromatic olefins such as styrene, divinylbenzene, and stilbene; alicyclic olefins such as vinyl cyclohexane; vinyl ethers such as ethyl vinyl ether; vinyl ketones such as methyl vinyl ketone, 1,5-hexadien-3-one, 2-methyl-1,5-hexadien-3-one; epoxy group-containing vinyl compounds such as glycidyl acrylate and allyl glycidyl ether; vinyl amines such as allyl amine, 2-(diethylamino)ethanol vinyl ether, 2-(diethylamino)ethyl acrylate, and 4-vinyl aniline; and the like can be given.

A compound shown by the formula: CH₂=CH-Q (wherein Q is a group containing at least one group selected from a methacryloyl group, acryloyl group, and vinyl silyl group) can also be used as a chain transfer agent in the present invention. The use of this compound enables the group Q to be introduced into the polymer terminal. The group Q at the terminal contributes to crosslinking at the time of post-crosslinking and thus to an increase in the crosslinking density.

As specific examples of the compound shown by the formula CH₂=CH-Q, compounds in which the Q is a group having a methacryloyl group such as vinyl methacrylate, allyl methacrylate, 3-buten-1-yl methacrylate, 3-buten-2-yl methacrylate, and styryl methacrylate; compounds in which the Q is a group having an acryloyl group such as allyl acrylate, 3-buten-1-yl acrylate, 3-buten-2-yl acrylate, 1-methyl-3-buten-2-yl acrylate, styryl acrylate, and ethylene glycol diacrylate; compounds in which the Q is a group having a vinyl silyl group such as allyl trivinyl silane, allyl methyl divinyl silane, and allyl dimethyl vinyl silane; and the like can be given. These chain transfer agents may be used either individually or in combination of two or more.

The amount of the chain transfer agent to be added is usually 0.01-10 parts by weight, and preferably 0.1-5 parts by weight for 100 parts by weight of the cycloolefin monomer. The amount of the chain transfer agent in this range ensures a high conversion ratio and efficient production of post-crosslinkable thermoplastic resin. If the amount of the chain transfer agent is too small, a thermoplastic resin may not be produced. If the amount of the chain transfer agent is too large, post-crosslinking may be difficult.

### (iv) Radical crosslinking agent

The radical crosslinking agent is a compound which reacts with the carbon-carbon double bond of the thermoplastic resin by a radical crosslinking reaction to produce a crosslinked resin.

As the radical crosslinking agent used in the present invention, an organic peroxide, a diazo compound, and the like can be given.

There are no specific limitations to the organic peroxide. For example, ketone peroxides such as methyl ethyl ketone peroxide, methyl isobutyl ketone peroxide, cyclohexanone peroxide, methyl cyclohexanone peroxide, and 3,3,5-trimethylcyclohexanone peroxide; acyl peroxides such as acetyl peroxide, propionyl peroxide, isobutyl peroxide, octanoyl peroxide, 3,5,5-trimethylhexanoyldecanoyl peroxide, lauroyl peroxide, benzoyl peroxide, 4-methylbenzoyl peroxide, 4-chlorobenzoyl peroxide, 2,4-dichlorobenzoyl peroxide, and acetylcyclohexanesulfonyl peroxide; hydroperoxides such as tert-butyl hydroperoxide, cumene hydroperoxide, diisopropylbenzene hydroperoxide, p-methane hydroperoxide, 2,5-dimethylhexane-2,5-dihydroperoxide, 1,1,3,3-tetramethylbutyl hydroperoxide; dialkyl peroxides such as di-tert-butyl peroxide, tert-butylcumyl peroxide, and dicumyl peroxide; peroxy ketals such as 1,1-bis(t-butylperoxydiisopropyl)benzene, 1,1-bis(t-butylperoxy)- 3,5,5-trimethylcyclohexane, and n-butyl-4,4'-bis (tert-butylperoxy)butane; alkyl peresters such as tert-butylperoxy acetate, tert-butylperoxy iso-butyrate, tert-butylperoxy octoate, tert-butylperoxy pivalate, tert-butylperoxy neodecanate, tert-butylperoxy-3,5,5-trimethylhexanoate, tert-butylperoxybenzoate, di-tert-butylperoxy phthalate, tert-butylperoxy iso-phthalate, tert-butylperoxy laurate, 2,5-dimethyl-2,5-dibenzoylperoxy hexane; peroxy carbonates such as di-2-ethylhexylperoxy dicarbonate, diisopropylperoxy dicarbonate, di-sec-butylperoxy carbonate, di-n-propylperoxy dicarbonate, dimethoxyisopropylperoxy dicarbonate, di-3-methoxybutylperoxy dicarbonate, di-2-ethoxyethylperoxy dicarbonate, and bis(4-tert-butylcyclohexyl)peroxy dicarbonate; water-soluble peroxides such as succinic acid peroxide; alkylsilyl peroxides such as t-butyltrimethylsilyl peroxide; and the like can be given.

Examples of the diazo compound include 4,4'-bisazidobenzal(4-methyl)cyclohexanone, 4,4'-diazidochalcone, 2,6-bis(4'-azidobenzal)cyclohexanone, 2,6-bis(4'-azidobenzal)-4-methylcyclohexanone, 4,4'-diazidodiphenylsulfone, 4,4'-diazidodiphenylmethane, 2,2'-diazidostilbene, and the like.

Of these, dialkyl peroxides are preferable due to a small hindrance to the metathesis polymerization reaction.

The amount of the radical crosslinking agent is usually 0.1-10 parts by weight, and preferably 0.5-5 parts by weight for 100 parts by weight of the cycloolefin monomers. If the amount of the radical crosslinking agent is too small, crosslinking is insufficient to produce a crosslinked resin with a high crosslink density; if the amount is too large, not only the crosslinking effect is saturated, but also there is a possibility that a thermoplastic resin and crosslinked resin having desired properties cannot be obtained.

In the present invention, a crosslinking co-agent can be used in combination with the radical crosslinking agent to improve the crosslinking effect. As the crosslinking co-agent, known crosslinking co-agents, for example, polyfunctional methacrylate compounds such as trimethylolpropane trimethacrylate; polyfunctional acrylate compounds such as ethylene glycol diacrylate; compounds having two or more allyl groups such as diallyl fumarate, diallyl phthalate, and triallyl cyanulate; and the like can be used without specific limitations.

Although there are no specific limitations, the amount of the crosslinking co-agent used is usually 0-100 parts by weight, and preferably 0-50 parts by weight for 100 parts by weight of the cycloolefin monomers.

### (v) Compound (α)

The compound (α) used in the present invention is at least one compound selected from the group consisting of the compounds having an alkoxyphenol structure with one or more substituents on the aromatic ring, compounds having an aryloxyphenol structure, and compounds having a catechol structure with two or more substituents on the aromatic ring. A compound with a radical capturing function (a retarder for radical crosslinking) which exhibits an effect of suppressing the radical crosslinking reaction by a radical crosslinking agent(delaying the radical crosslinking reaction rate) is particularly preferable. When the compound (α) is a retarder for radical crosslinking, a thermoplastic resin composition containing the compound (α) which does not crosslink unless the composition is heated to a molten state even if the composition contains a radical crosslinking agent can be obtained. Therefore, the resulting thermoplastic resin composition exhibits excellent storage stability with minimal change in the surface hardness during storage. Moreover, such a polymerizable composition has an effect of suppressing the crosslinking reaction during bulk polymerization of cycloolefin monomers which is discussed later.

Any compound can be used as the compound (α) in the present invention without any specific limitations inasmuch as the compound has an alkoxyphenol structure with one or more substituents on the aromatic ring, an aryloxyphenol structure, or a catechol structure with two or more substituents on the aromatic ring.

There are no specific limitations to the substituent, which may be either a polar group or a non-polar group. A non-polar group is more preferable, with an alkyl group being particularly preferable.

The alkyl group may be either linear or branched, with a branched alkyl group being more preferable. Secondary and tertiary alkyl groups are more preferable than a primary alkyl group, with tertiary alkyl groups being particularly preferable.

As examples of the compound having an alkoxyphenol structure with one or more substituents on the aromatic ring, (a) a compound having an alkoxyphenol structure with a primary alkyl group substituted, (b) a compound having an alkoxyphenol structure with a secondary alkyl group substituted, (c) a compound having an alkoxyphenol structure with a tertiary alkyl group substituted, and (d) a compound having an alkoxyphenol structure with a substitutent other than the above substituent can be given.

As the compound (a), 2-methyl-4-methoxyphenol, 3-methyl-4-methoxyphenol, 2,6-dimethyl-4-ethoxyphenol, 2,6-diethyl-4-methoxyphenol, and the like can be given. As the compound (b), 2,6-diisopropyl-4-methoxyphenol and the like can be given. As specific examples of the compound (c), 2-t-butyl-4-methoxyphenol, 2-t-butyl-4-ethoxyphenol, 3-t-butyl-4-methoxyphenol, 3-t-butyl-4-ethoxyphenol, 2,6-di-t-butyl-4-methoxyphenol, 2,6-di-t-butyl-4-ethoxyphenol, 2,5-di-t-butyl-4-methoxyphenol, 3,5-di-t-butyl-2-methoxyphenol, 2,4-di-t-butyl-5-methoxyphenol, 2,6-bis(1,1-dimethylbutyl)-4-methoxyphenol, and 2,6-bis(1,1,3,3-tetramethylbutyl)-4-methoxyphenol can be given. As the compound (d), 2,6-diphenoxyphenol, 4-methyl-2,6-diphenoxyphenol, 3,4,5-trimethoxyphenol, and the like can be given.

As the compound having an aryloxyphenol structure, 4-phenoxyphenol, 2-methyl-4-phenoxyphenol, 3-methyl-4-phenoxyphenol, 2,6-diisopropyl-4-phenoxyphenol, 2,6-di-t-butyl-4-phenoxyphenol, bis(3,5-di-t-butyl-4-hydroxyphenyl)ether, and the like can be given.

As the compound having a catechol structure with two or more substituents on the aromatic ring, 3,5-di-t-butyl catechol, 3-t-butyl-4-methoxy catechol, and the like can be given.

Of these compounds, the compound having an alkoxyphenol structure with one or more substituents on the aromatic ring or the compound having an aryloxyphenol structure are preferable as the compound (α) to ensure excellent radical crosslinking retarding effect, with the compound having an alkoxyphenol structure with one or more substituents on the aromatic ring being particularly preferred. The above compound (c) having an alkoxyphenol structure with a tertiary alkyl group substituted is more preferable, with a compound having a 4-alkoxyphenol structure with tertiary alkyl groups substituted at the 2 and 6 positions being particularly preferable.

The amount of the compound (α) is usually 0.001-1 mol, preferably 0.01-1 mol, more preferably 0.01-0.5 mol, and particularly preferably 0.05-0.5 mol for one mol of the radical crosslinking agent. If the amount of the compound (α) is less than 0.001 mol for one mol of the radical crosslinking agent, a radical crosslinking retarding effect is not sufficiently exhibited; if more than one mol, on the other hand, radical crosslinking may be insufficient.

The polymerizable composition of the present invention containing the radical crosslinking agent in an amount of 0.1-10 parts by weight per 100 parts by weight of the cycloolefin monomer and the compound (α) in an amount of 0.001-1 mol per one mol of the radical crosslinking agent is particularly preferable.

### 2) Thermoplastic resin composition

The thermoplastic resin composition of the present invention comprises (1) a cycloolefin thermoplastic resin, (2) a radical crosslinking agent, and (3) the compound (α).

### (1) Cycloolefin thermoplastic resin

The cycloolefin thermoplastic resin used in the present invention is a thermoplastic resin obtained by polymerizing cycloolefin monomers.

As the cycloolefin monomer, cycloolefin monomers previously mentioned in the section of the polymerizable composition can be used.

Although either the later-described solution polymerization method or bulk polymerization method can be used for polymerizing cycloolefin monomers, the bulk polymerization method is more preferable.

The number average molecular weight (Mn) of the cycloolefin thermoplastic resin measured by gel permeation chromatography (expressed in terms of polystyrene) is preferably 1,000-500,000, and more preferably 5,000-200,000.

Thermoplasticity of the resulting resin can be confirmed by investigating whether or not the resin dissolves in a solvent. Specifically, a resin is a thermoplastic resin if it dissolves in a solvent and a crosslinked resin if it does not dissolve.

As examples of the solvent to confirm the termoplasticity of the resin, aromatic hydrocarbons such as benzene and toluene; ethers such as diethyl ether and tetrahydrofuran; and halogenated hydrocarbons such as dichloromethane and chloroform can be given.

The cycloolefin thermoplastic resin used in the present invention is not necessarily a thermoplastic resin in its entirety, but may be partially crosslinked. When a molded resin product with a certain thickness is produced by bulk polymerization of a norbomene monomer, the polymerization reaction temperature is partially increased in the center of the molded product and part of the resin is crosslinked due to difficulty in releasing the heat of polymerization reaction from the center section. Even in such a case, the molded product is acceptable if at least the surface is a thermoplastic resin.

As the radical crosslinking agent (2) and the compound (α) (3) used for producing the thermoplastic resin composition, the same compounds as the radical crosslinking agent (iv) and the compound (α) (v) as mentioned in the section of the polymerizable composition can be given.

In the thermoplastic resin composition of the present invention, the compound (α) is preferably a retarder for radical crosslinking or a compound having an alkoxyphenol structure with one or more substituents on the aromatic ring.

The thermoplastic resin composition of the present invention preferably contains the radical crosslinking agent in an amount of 0.1-10 parts by weight per 100 parts by weight of the cycloolefin thermoplastic resin and the compound (α) in an amount of 0.001-1 mol per one mol of the radical crosslinking agent.

In the present invention, a crosslinking co-agent can be used in combination with the radical crosslinking agent to improve the crosslinking effect. As the crosslinking co-agent, the crosslinking co-agents previously mentioned in the section of the polymerizable composition can be used without any specific limitations. Although there are no specific limitations, the amount of the crosslinking co-agent used is usually 0-100 parts by weight, and preferably 0-50 parts by weight for 100 parts by weight of the cycloolefin thermoplastic resin.

The thermoplastic resin composition of the present invention is preferably in the form of a film or impregnated in a fiber material.

The thermoplastic resin composition of the present invention may contain, in addition to (1) the cycloolefin thermoplastic resin, (2) radical crosslinking agent, and (3) compound (α), various additives such as a reinforcing material, modifier, antioxidant, flame retardant, filler, coloring agent, and light stabilizer.

As examples of the reinforcing material, glass fiber, glass fabric, paper substrate, and nonwoven glass fabric can be given. As the modifier, elastomers known in the art can be given. As examples of the antioxidant, various antioxidants for plastics or rubbers of a hindered phenol-type, phosphorus-type, amine-type, and the like can be given. As the flame retardant, a phosphorus-containing flame retardant, nitrogen-containing flame retardant, halogen-containing flame retardant, metal hydroxide flame retardant such as aluminum hydroxide, and the like can be given. As examples of the filler, inorganic fillers such as glass powder, carbon black, silica, talc, calcium carbonate, mica, alumina, titania, zirconia, mullite, cordierite, magnesia, clay, barium sulfate, barium titanate, metal powder, and ferrite; organic fillers such as wood powder and polyethylene powder; and the like can be given. As the coloring agent, commonly known dyes, pigments, and the like can be used. As examples of the light stabilizer, benzotriazole UV absorbers, benzophenone UV absorbers, salicylate UV absorbers, cyano acrylate UV absorbers, oxalinide UV absorbers, hindered amine UV absorbers, and benzoate UV absorbers can be given. These additives may be used either individually or in combination of two or more.

The amount of the additives is usually 0.001-100 parts by weight for 100 parts by weight of the thermoplastic resin.

The thermoplastic resin composition of the present invention can be obtained by mixing the above components in any optional method. When a cycloolefin-type thermoplastic resin is produced by the solution polymerization method, the resulting polymer mixture can be used as a resin varnish as is by adding a radical crosslinking agent and the compound (α) after the polymerization reaction.

There are no specific limitations to the form of the thermoplastic resin composition of the present invention. A thermoplastic resin composition film and a prepreg of a fiber material impregnated with the thermoplastic resin composition can be given as preferable examples.

### 3) Process for producing thermoplastic resin composition

The thermoplastic resin composition of the present invention can be produced by polymerizing the polymerizable composition (A) containing a cycloolefin monomer, a metathesis polymerization catalyst, a chain transfer agent, a radical crosslinking agent, and the compound (α). As the cycloolefin monomer, metathesis polymerization catalyst, chain transfer agent, radical crosslinking agent, and compound (α), those previously mentioned in the section of the polymerizable composition can be used.

Either the solution polymerization method or bulk polymerization method can be used. The bulk polymerization method is more preferable in the present invention in view of the excellent productivity.

In case of the solution polymerization method, the polymerization temperature is usually in the range of -30°C to 200°C. The polymerization time is usually from one minute to 100 hours.

When the solution polymerization method is used, the resulting polymer may be optionally hydrogenated after the polymerization reaction. The catalytic reduction with hydrogen using a hydrogenation catalyst can be given as the method of hydrogenation.

The bulk polymerization is a method of preparing a polymerizable composition (A) and heating the composition to a prescribed temperature to polymerize monomers.

There are no specific limitations to the method for preparing the polymerizable composition (A). For example, a method of preparing a monomer solution comprising the cycloolefin monomer and a catalyst solution by dissolving or dispersing the metathesis polymerization catalyst in an appropriate solvent, and mixing the two solutions immediately before the polymerization can be given. In this case, a chain transfer agent, a radical crosslinking agent, and a compound (α) may be added either to the monomer solution or the catalyst solution. Alternatively, these components may be added to a solution obtained by mixing the monomer solution and the catalyst solution.

Any solvent inert to the reaction can be used without any specific limitations as the solvent for dissolving or dispersing the metathesis polymerization catalyst. For example, aliphatic hydrocarbon solvents such as pentane, hexane, heptane, octane, and decane; alicyclic hydrocarbon solvents such as cyclopentane, cyclohexane, methylcyclohexane, decahydronaphthalene, and bicycloheptane; aromatic hydrocarbon solvents such as benzene, toluene, and xylene; nitrogen-containing hydrocarbon solvents such as nitromethane, nitrobenzene, and acetonitrile; ether solvents such as diethyl ether and tetrahydrofuran; halogenated hydrocarbon solvents such as chloroform, carbon tetrachloride, 1,2-dichloroethane, chlorobenzene, and dichlorobenzene; and the like can be given. These solvents can be used either individually or in combination of two or more. In addition, an antioxidant, plasticizer, or elastomer which is in liquid state may be used as a solvent to the extent not reducing the activity of the metathesis polymerization catalyst.

As the method for polymerizing the polymerizable composition (A) by bulk polymerization, (a) a method of pouring or applying the polymerizable composition (A) onto a supporting body and polymerizing the composition by bulk polymerization, (b) a method of polymerizing the polymerizable composition (A) in a mold, (c) a method of impregnating a fiber material with the polymerizable composition (A) and polymerizing the composition by bulk polymerization, and the like can be given.

A thermoplastic resin composition film can be obtained if the method (a) is followed. As the supporting body used in this method, resins such as polyethylene terephthalate, polypropylene, polyethylene, polycarbonate, polyethylenenaphthalate, polyallylate, and nylon; metals such as iron, stainless steel, copper, aluminum, nickel, chromium, gold, and silver; and the like can be given. Although there are no specific limitations to the shape of the supporting body, a metallic foil or a resin film is preferably used. The thickness of the metallic foil or resin film is usually 1-150 µm, preferably 2-100 µm, and still more preferably 3-75 µm from the viewpoint of workability and the like.

There are no specific limitations to the method of applying the polymerizable composition (A) to the supporting body. A spray coating method, dip coating method, roll coating method, curtain coating method, die coating method, slit coating method, and the like can be given.

Although not specifically limited, as the method of heating the polymerizable composition (A) to a prescribed temperature, a method of heating the composition by placing the supporting body on a heating plate, a method of heating while applying pressure using a press machine (heat-press), a method of pressing using a heated roll, a method of using a furnace, and the like can be given.

The thickness of the thermoplastic resin composition film obtained in this manner is usually 15 mm or less, preferably 10 mm or less, and more preferably 5 mm or less.

A thermoplastic resin composition molded product can be obtained if the method (b) of polymerizing in a mold is followed. The form of the molded product includes a sheet, film, plate, column, cylinder, and multiangular prism, for example.

There are no specific limitations to the shape, material, and dimension of the mold. For example, a conventionally known split mold having a core and cavity can be used. The core and cavity are fabricated so that a vacant space may be provided conforming to the shape of a desired molded product. The reaction fluid is charged into the vacant space (cavity) and polymerized by bulk polymerization.

In the present invention, a molded product of the thermoplastic resin composition in the form of a sheet or film can also be obtained by providing plate molds (e.g. glass boards or metal plates) and a spacer with a prescribed thickness, interposed between two sheets of plate molds, injecting the reaction fluid into the space formed by the two sheets of plate molds and the spacer, and effecting the bulk polymerization therein.

The filling pressure (injection pressure) for filling the reaction fluid in the cavity of the mold is usually 0.01-10 MPa, and preferably 0.02-5 MPa. If the filling pressure is too low, there is a tendency for the transfer surface formed in the inner surface of the cavity not to be transferred in a good order. Too high a filling pressure requires a highly rigid mold and is, therefore, uneconomical. The mold clamping pressure is usually within the range of 0.01-10 MPa.

The method (c) can produce a prepreg impregnated with a thermoplastic resin. The fiber material used here is organic and/or inorganic fiber and includes, for example, known fibers such as glass fiber, carbon fiber, aramid fiber, polyethylene terephthalate fiber, vinylon fiber, polyester fiber, amide fiber, metal fiber, and ceramic fiber. These fibers can be used either individually or in combination of two or more. As the form of the fiber material, a mat, cloth, nonwoven fabric, and the like can be given.

A fiber material is impregnated with the polymerizable composition (A), for example, by a method comprising applying a prescribed amount of the polymerizable composition (A) to the fiber material by a known method such as spray coating, dip coating, roll coating, curtain coating, die coating, or slit coating, layering a protective film over the coated polymerizable composition (A), as required, and pressing the resulting material using a roll or the like.

After the fiber material has been impregnated with the polymerizable composition (A), the resulting product (impregnated material) is heated to a prescribed temperature to polymerize the composition (A) by bulk polymerization, whereby a thermoplastic resin-impregnated prepreg can be obtained.

There are no specific limitations to the method for heating the impregnated material. The same method as the above method (a) can be used. In this instance, it is possible to heat the impregnated material placed on a supporting body or to previously set the fiber material in a mold and impregnate the fiber material with the polymerizable composition (A), then follow the method (b) for bulk polymerization of the composition.

Since the polymerizable composition (A) has a low viscosity as compared with a conventional resin varnish, the composition can cause the fiber material to be excellently impregnated therewith. The resulting prepreg thus contains the fiber material homogeneously impregnated with the thermoplastic resin. Because the prepreg can be obtained by impregnating the fiber material with the polymerizable composition (A), followed by heating to a prescribed temperature for bulk polymerization, the process does not require a step of removing a solvent from the impregnated resin varnish that was indispensable in conventional processes. The process therefore exhibits good productivity and is free from problems due to a residual solvent such as odor, swelling, and the like. Furthermore, since the thermoplastic resin composition of the present invention is excellent in storage stability, the resulting prepreg is also excellent in storage stability.

In any of the above methods (a), (b), and (c), the polymerization temperature is usually 80-200°C, and preferably 100-200°C. The polymerization time is usually 10 seconds to 20 minutes, and preferably within five minutes.

The polymerization reaction starts when the polymerizable composition (A) is heated to a prescribed temperature. This polymerization reaction is an exothermic reaction. Thus, once the bulk polymerization begins, the temperature of the reaction solution will rapidly increase and reach a peak temperature in a short time (for example, about 10 seconds to 5 minutes). If the peak temperature during the polymerization reaction is too high, the crosslinking reaction proceeds in addition to the polymerization reaction, thereby making it difficult to obtain a thermoplastic resin. Therefore, to cause only the polymerization reaction to proceed, while preventing the crosslinking reaction from occurring, the peak temperature of the bulk polymerization is preferably controlled to lower than 200°C.

The peak temperature during the bulk polymerization is more preferably equivalent to or less than the one-minute half-life temperature of the radical crosslinking agent. The one minute half-life temperature here refers to the temperature at which one half of the radical crosslinking agent decomposes in one minute. For example, the one minute half-life temperature of di-t-butylperoxide is 186°C and that of 2,5-dimethyl-2,5-bis(t-butylperoxy)-3-hexine is 194°C.

To prevent overheating due to the heat of the polymerization reaction, it is possible to retard the reaction by adding a reaction retarder to the polymerizable composition (A).

As examples of the reaction retarder that can be used, acyclic 1,5-diene compounds such as 1,5-hexadiene, 2,5-dimethyl-1,5-hexadiene, (cis, cis)-2,6-octadiene, (cis, trans)-2,6-octadiene, (trans, trans)-2,6-octadiene; acyclic 1,3,5-triene compounds such as (trans)-1,3,5-hexatriene, (cis)-1,3,5-hexatriene, (trans)-2,5-dimethyl-1,3,5-hexatriene, (cis)-2,5-dimethyl-1,3,5-hexatriene; phosphines such as triphenyl phosphine, tri-n-butyl phosphine, and methyl diphenylphosphine; and Lewis bases such as aniline can be given.

Among the above-mentioned cycloolefin monomers, those having a 1,5-diene structure or 1,3,5-triene structure in the molecule function as a reaction retarder. As specific examples of such cycloolefin monomers, monocyclic compounds such as 1,5-cyclooctadiene, 1,5-dimethyl-1,5-cyclooctadiene, 1,3,5-cycloheptatriene, (cis, trans, trans)-1,5,9-cyclododecatriene, 4-vinylcyclohexene, and dipentene; polycyclic compounds such as 5-vinyl-2-norbornene, 5-isopropenyl-2-norbornene, and 5-(1-propenyl)-2-norbornene; and the like can be given.

When the reaction retarder is added, the amount is usually in the range of 0.001-5 wt%, and preferably 0.002-2 wt% of the monomer solution. If the amount of the reaction retarder is less than 0.001 wt%, the reaction retarding effect is not exhibited. If the amount is more than 5 wt%, on the other hand, the product properties may be impaired due to the reaction retarder which remains in the polymer. There is also a possibility that the polymerization reaction may not sufficiently proceed.

### 4) Crosslinked resin and process for producing the crosslinked resin

The crosslinked resin of the present invention is prepared by crosslinking the thermoplastic resin composition of the present invention. Specifically, the crosslinked resin can be obtained by heating the cycloolefin thermoplastic resin (hereinafter referred to as "thermoplastic resin" at times) of the thermoplastic resin composition of the present invention to a molten state and continuing the heating to proceed the crosslinking reaction. The heating temperature to crosslink the thermoplastic resin is usually 150-250°C, preferably 170-250°C, and still more preferably 180-220°C. The crosslinking temperature is preferably higher than the ten-minute half-life temperature of the radical crosslinking agent. The ten minute half-life temperature here refers to the temperature at which one half of the radical crosslinking agent decomposes in ten minutes. For example, the ten minute half-life temperature of di-t-butylperoxide is 162°C and that of 2,5-dimethyl-2,5-bis(t-butylperoxy)-3-hexine is 170°C. Although there are no specific limitations, the time for heating the thermoplastic resin to molten state and crosslink the resin is usually from several minutes to several hours.

There are no specific limitations to the method for heating the thermoplastic resin to a molten state and crosslinking the resin. When the thermoplastic resin composition is in the form of a film, a method of laminating and heat-pressing the film is preferable. The pressure applied for heat-pressing the film is usually 0.5-20 MPa, preferably 1-10 MPa, still more preferably 2-10 MPa, and particularly preferably 3-10 MPa. The heat-pressing is carried out using a known pressing machine having a press frame mold for forming plates, a press-forming machine such as an SMC (sheet mold compound) or a BMC (bulk mold compound), and the like. These methods exhibit excellent productivity.

### 5) Crosslinked resin composite material

The crosslinked resin composite material of the present invention is prepared by laminating the thermoplastic resin composition on a substrate and crosslinking the thermoplastic resin composition. Since the thermoplastic resin composition used in the present invention has excellent fluidity, the resultant crosslinked resin composite material is firmly adhered to the substrate and can maintain strong adhesiveness.

Although there are no specific limitations to the method of crosslinking the thermoplastic resin, a method of heat-pressing the thermoplastic resin laminated on the substrate is preferable for producing the crosslinked resin composite material with sufficient productivity. The same heat-pressing conditions as mentioned for the manufacturing method of the crosslinked resin are applicable.

As the substrate, a metallic foil, a printed-wiring board, a conductive polymer film, other resin films, and the like can be mentioned, with a metallic foil or a printed-wiring board being preferable.

A crosslinked resin-metal clad laminate can be obtained by laminating the thermoplastic resin composition of the present invention on a metallic foil and crosslinking the thermoplastic resin.

As examples of the metallic foil, a copper foil, aluminum foil, nickel foil, chromium foil, gold foil, silver foil, and the like can be given. Of these, a copper foil is preferable.

The surface of the metallic foil may be treated with a silane coupling agent, a thiol coupling agent, a titanate coupling agent, various adhesives, and the like. A silane coupling agent represented by the following formula (3) and a thiol coupling agent represented by the following formula (4) are particularly preferable surface treating agents.

RSiXYZ (3)

In the formula (3) of the silane coupling agent, R is a group having a double bond, a mercapto bond, or an amino group at the terminal, X and Y individually represent a hydrolyzable group, a hydroxyl group, or an alkyl group, and Z represents a hydrolyzable group or a hydroxyl group.

As specific examples of the silane coupling agent of the formula (3), allyltrimethoxysilane, 3-butenyltrimethoxysilane, styryltrimethoxysilane, N-β-(N-(vinylbenzyl)aminoethyl)-γ-aminopropyltrimethoxysilane and its salt, allyltrichlorosilane, allylmethyldichlorosilane, styryltrichlorosilane, vinyltrimethoxysilane, vinyltriethoxysilane, vinyltriacetoxysilane, vinyltris(2-methoxyethoxy)silane, vinyltrichlorosilane; β-methacryloxyethyltrimethoxysilane, β-methacryloxyethyltriethoxysilane, γ-methacryloxypropyltrimethoxysilane, δ-methacryloxybutyltrimethoxysilane, γ-acryloxypropyltrimethoxysilane, γ-mercaptopropyltrimethoxysilane, γ-mercaptopropylmethyldimethoxysilane, γ-aminopropyltrimethoxysilane, N-phenyl-γ-aminopropyltrimethoxysilane, N-β-(aminoethyl)-γ-aminopropyltrimethoxysilane, and the like can be given.

T(SH)n (4)

In the formula (4) of the thiol coupling agent, T represents an aromatic ring, an aliphatic ring, a heterocyclic, or an aliphatic chain, and n is an integer of 2 or more.

As examples of the thiol coupling agent, 2,4,6-trimercapto-1,3,5-triazine, 2,4-dimercapto-6-dibutylamino-1,3,5-triazine, 2,4-dimercapto-6-anilino-1,3,5-triazine, and the like can be given.

If the thermoplastic resin composition is laminated with a metallic foil and heat-pressed, the thermoplastic resin portion is melted and is caused to adhere with the metallic foil, then the crosslinking reaction proceeds to obtain a crosslinked resin. A crosslinked resin-metal clad laminate in which the crosslinked resin and metallic foil is firmly bonded can be obtained using the process of the present invention. The peel-off strength of the metallic foil from the resulting crosslinked resin-metal clad laminate measured according to JIS C6481 is preferably 0.8 kN/m or more, and more preferably 1.2 kN/m or more.

A multilayer printed-wiring board can be obtained by laminating a film of the thermoplastic resin composition of the present invention on a printed-wiring board and crosslinking the thermoplastic resin Any known printed-wiring boards commonly used for inner layers can be used without specific limitations. According to the present invention, the cycloolefin crosslinked resin having superior electric insulation properties and mechanical strength can excellently adhere to the printed-wiring board for inner layers, thereby efficiently producing firmly adhered multilayer printed-wiring boards.

### EXAMPLES AND COMPARATIVE EXAMPLES

The present invention will be described in more detail by way of Examples and Comparative Examples. The present invention, however, should not be limited to these Examples.

### Examples 1-3

A 10 ml glass flask was charged with 51 mg of benzylidene(1,3-dimesitylimidazolidin-2-ylidene)(tricyclohexylphosphine)ruthenium dichloride and 79 mg of triphenylphosphine. 1.1 ml of toluene was added to dissolve the mixture to prepare a catalyst solution with a ruthenium concentration of 0.05 mol/l.

A 100 ml polyethylene bottle was charged with 0.38 mmol of the additive indicated in Table 1, 22.5 g of tetracyclo[6.2.1.1^{3,6}.0^{2,7}]dodeca-4-ene, 7.5 g of 2-norbornene, 0.43 ml of allyl methacrylate, 0.33 g of di-t-butylperoxide (one minute half-life temperature: 186°C, 2.3 mmol as active oxygen), and 0.12 ml of the above-mentioned catalyst solution. The mixture was stirred to obtain a polymerizable reaction solution. The amount of the additive added was 0.17 equivalent to the active oxygen.

Three sheets of glass cloth (each cut into 200 mm × 200 mm, thickness: 0.092 mm, Product #2116/AS891AW, manufactured by Asahi-Schwebel Co., Ltd.) were layered on a glass cloth-reinforced polytetrafluoroethylene (PTFE) resin film (cut into 300 mm × 300 mm, thickness: 0.08 mm, Product #5310, manufactured by Saint-Gobain K. K.). About one half the amount of the polymerizable reaction solution was poured onto the glass cloth, which was then covered with another glass cloth-reinforced PTFE resin film (the same film as that mentioned above), followed by pressing with a roll to cause the glass cloth sheets to be impregnated with the polymerizable composition.

The glass cloth-reinforced PTFE resin film was attached to an aluminum plate heated to 145°C for one minute to polymerize the polymerizable composition. Thereafter, the glass cloth-reinforced PTFE resin films were removed from both sides to obtain a prepreg.

Three sheets of the prepreg (each cut into 87 mm × 87 mm) were inserted in a square frame (inner size: 90 mm × 90 mm, thickness: 1 mm). A PTFE resin film (cut into 120 mm × 120 mm, thickness: 0.05 mm) was attached to the top and bottom surfaces of the prepreg sheets, followed by heat-pressing for 15 minutes at 4.1 MPa and 200°C. After cooling to 100°C or less while applying pressure, the sample was removed to obtain glass fiber-reinforced laminates of Examples 1-3.

A clearance between the layers, if present, looks white when observed with the naked eye (the layers are detached if this part is removed from the laminate by cutting). The ratio of the area of interlayer adhesion failure to the entire area of the glass fiber-reinforced laminates of Examples 1-3 was determined. The results are shown in Table 1.

### Comparative Examples 1-4

The glass fiber-reinforced laminates of Comparative Examples 1-4 were obtained using the additives indicated in Table 1 in the same manner as in Examples 1-3. The ratio of the area of interlayer adhesion failure to the entire area of the glass fiber-reinforced laminates of Comparative Examples 1-4 was determined. The results are shown in Table 1.

**TABLE 1**

| | Additive | Interlayer adhesion failure (%) |
|---|---|---|
| Example 1 | 2,6-di-t-butyl-4-methoxyphenol | 0 |
| Example 2 | 2-t-butyl-4-methoxyphenol | 9 |
| Example 3 | 3,5-di-t-butylcatechol | 12 |
| Comparative Example 1 | 2,6-di-t-butyl-4-methylphenol | 30 |
| Comparative Example 2 | 4,4'-thiobis(3-methyl-6-t-butylphenol) | 29 |
| Comparative Example 3 | 4-methoxyphenol | 29 |
| Comparative Example 4 | 4-t-butylcatechol | 30 |

It can be seen from the results shown in Table 1 that when the compound having an alkoxyphenol structure with at least one substituent on the aromatic ring (Examples 1 and 2) or the compound having a catechole structure with at least two substituents on the aromatic ring (Example 3) was added to the reaction system as the additive, the glass fiber-reinforced laminate with excellent interlayer adhesion can be obtained. When 2,6-di-t-butyl-4-methylphenol, 4,4'-thiobis(3-methyl-6-t-butylphenol), 4-methoxyphenol, or 4-t-butylcatechol (Comparative Examples 1-4) was added to the reaction system, on the other hand, the resulting glass fiber-reinforced laminate exhibited poor interlayer adhesion.

### Example 4

The glass fiber-reinforced laminate of Example 4 was obtained in the same manner as in Example 2, except that the amount of 2-t-butyl-4-methoxyphenol was increased to 1.1 mmol. The ratio of the area of interlayer adhesion failure to the entire area of the resulting glass fiber-reinforced laminate was determined. The interlayer adhesion of the glass fiber-reinforced laminate was improved, with no white part due to interlayer adhesion failure being observed (interlayer adhesion failure: 0 %).

### Example 5

Two drops of acetic acid were added to 60 g of distilled water. After the addition of 0.18 g of vinyl-tris(2-methoxyethoxy)silane ("A-172" manufactured by Nippon Unicar Co., Ltd.), the mixture was stirred for 10 minutes to hydrolyze and dissolve the vinyl-tris(2-methoxyethoxy)silane, thereby obtaining a silane solution. The silane solution was applied to a rough surface of an electrolysis copper foil (GTS-treated rough surface, thickness: 0.018 mm, manufactured by Furukawa Circuit Foil Co., Ltd.) using absorbent cotton impregnated with the silane solution. The coating was dried for one hour at 130°C in a nitrogen atmosphere.

Three sheets of prepreg (each cut into 87 mm × 87 mm) obtained in Example 1 were inserted in a square frame (inner size: 90 mm × 90 mm, thickness: 1 mm). The copper foil (cut into 115 mm × 115 mm) treated with the silane was attached to the top and bottom of the prepreg sheet so that the rough surface of the foil comes in contact with the pregreg, followed by heat-pressing for 15 minutes at 4.1 MPa and 200°C. After cooling to 100°C or less while applying pressure, the sample was removed to obtain a both-side copper clad laminate.

The peel-off strength of the copper foil from the resulting both-side copper clad laminate was measured according to JIS C6481 and found to be 1.4 kN/m. The solder heat resistance test was carried out in a solder bath at 260°C for 20 seconds to confirm that no swelling was observed. The interlayer adhesion failure was 0 %.

The bending test of the fiber-reinforced resin (thickness: 1.5 mm) after peeling the copper foil was carried out to confirm that the bending modulus of elasticity and the bending strength were respectively 12 GPa and 380 MPa.

The dielectric constant and dielectric loss tangent were measured using an impedance analyzer ("E4991" manufactured by Agilent Technologies) to find that the dielectric constant and dielectric loss tangent were respectively 3.5 and 0.0013 at 100 MHz and 3.5 and 0.0020 at 1 GHz.

### Example 6

A glass flask was charged with 30 g of dicyclopentadiene, 0.43 ml of allyl methacrylate, and 150 g of cyclohexane. A catalyst solution prepared by dissolving 2.0 mg of benzylidene(1,3-dimesityl-4-imidazoline-2-ylidene)-(tricyclohexylphosphine)ruthenium dichloride in 1 ml of toluene was added to the mixture, followed by stirring for one hour at 70°C. 20 mg of ethyl vinyl ether was added to terminate the metathesis polymerization reaction.

0.39 g of 1,3-di(2-t-butylperoxyisopropyl)benzene (one minute half-life temperature: 175°C, 2.3 mmol as active oxygen) and 89 mg of 2,6-di-t-butyl-4-methoxyphenol were added to the solution to prepare a varnish.

A glass cloth-reinforced PTFE resin film (the same as that used in Example 1) was placed on a butt and covered with one sheet of glass cloth (the same as that in Example 1). The glass cloth was impregnated with the varnish by slowly dripping the varnish and allowed to stand to dry. This procedure was repeated three times, followed by final drying for one hour at 50°C using a vacuum dryer to obtain a pregreg.

Ten sheets of the prepreg (each cut into 87 mm × 87 mm) were inserted in a square frame (inner size: 90 mm × 90 mm, thickness: 1 mm). A PTFE resin film (cut into 120 mm × 120 mm, thickness: 0.05 mm) was attached to the top and bottom surfaces of the prepreg sheets, followed by heat-pressing for 15 minutes at 4.1 MPa and 200°C. After cooling to 100°C or less while applying pressure, the sample was removed to obtain a glass fiber-reinforced laminate.

Interlayer adhesion of the glass fiber-reinforced laminate was observed with the naked eye and no interlayer clearance was confirmed (interlayer adhesion failure: 0 %).

### Comparative Example 5

The same experiment as in Example 6 was carried out, except for not adding 2,6-di-t-butyl-4-mehoxyphenol. A clearance was observed in the resulting glass fiber-reinforced laminate (interlayer adhesion failure: 29 %).

### Example 7

A 100 ml polyethylene bottle was charged with 0.6 g of fumed silica (Aerosil 200 manufactured by Nippon Aerosil Co., Ltd.), 89 mg of 2,6-di-t-butyl-4-methoxyphenol, 22.5 g of tetracyclo[6.2.1.1^{3,6}.0^{2,7}]dodeca-4-ene, 7.5 g of 2-norbornene, 0.37 ml of allyl methacrylate, and 0.42 g of 2,5-dimethyl-2,5-bis(t-butylperoxy)-3-hexyne (one minute half-life temperature: 194°C). After the addition of 0.12 ml of the catalyst solution used in Example 1, the mixture was stirred to obtain a polymerizable composition 1.

The polymerizable composition 1 was applied to the surface of the glass cloth-reinforced PTFE resin film (the same as that used in Example 1) using a coating roll. The coating was then covered with another glass cloth-reinforced PTFE resin film. The resultant material was attached to an aluminum plate heated to 145°C for one minute to polymerize the composition. Thereafter, the glass cloth-reinforced PTFE resin film was removed to obtain a resin film with a thickness of 0.2 mm. A part of the film was dipped in toluene to dissolve the resin. The amount of residual monomers in the solution was determined by gas chromatography. Based on the resulting amount of residual monomers, the conversion ratio was calculated to be 98 wt%.

Five sheets of the film (cut into 10 mm × 10 mm) were layered on an aluminum plate heated to 180°C to confirm that the films were immediately melted. The change in the molten state over time was observed to find that the viscosity was gradually increased to the extent that the material was gelatinized and lost fluidity after seven and half minutes from the time when the films were placed on the aluminum plate. The gelatinized material was allowed to stand on the aluminum plate for one hour to complete the crosslinking reaction.

The resulting crosslinked resin was immersed in toluene at 23°C for one day to confirm that the resin was not dissolved, but only swelled. The swelling rate determined from the weights before and after the immersion was 124 %.

A 24 hour accelerated heating test was carried out in a nitrogen atmosphere at 100°C to examine the storage stability of the resin film. After 24 hours, the resin film was placed on an aluminum plate heated to 180°C to confirm that the film was immediately melted and thereafter gelatinized to lose fluidity.

### Comparative Example 6

A resin film with a thickness of 0.2 mm was obtained in the same manner as in Example 7, except for not adding 2,6-di-t-butyl-4-methoxyphenol.

A part of the film was dipped in toluene to dissolve the resin. The amount of residual monomers in the solution was determined by gas chromatography. Based on the resulting amount of residual monomers, the conversion ratio was calculated to be 98 wt%.

Five sheets of the film (cut into 10 mm × 10 mm) were layered on an aluminum plate heated to 180°C to confirm that the films were immediately melted. The change in the molten state over time was observed to find that the viscosity was gradually increased to the extent that the material was gelatinized and lost fluidity after three minutes and 10 seconds from the time when the films were placed on the aluminum plate. The gelatinized material was allowed to stand on the aluminum plate for one hour to complete the crosslinking reaction.

The resulting crosslinked resin was immersed in toluene at 23°C for one day to confirm that the resin was not dissolved, but only swelled. The swelling rate determined from the weights before and after the immersion was 119 %.

A 24 hour accelerated heating test was carried out in the same manner as in Example 8 using the resin film. After 24 hours, the resin film was placed on an aluminum plate heated to 180°C to confirm that the film was not melted.

Example 7 and Comparative Example 6 have shown that the addition of 2,6-di-t-butyl-4-methoxyphenol can delay the crosslinking reaction without unduly deteriorating the crosslink density (swelling rate) of the resin after crosslinkage and improve the storage stability by inhibiting the crosslinking reaction from proceeding in the resin before crosslinkage during storing.

### Example 8

The resin film obtained in Example 7 was attached to both sides of a glass epoxy both-side copper clad laminate (cut into 80 mm × 80 mm, thickness: 1 mm,) microetched using a surface roughener ("CZ-8100" by MEC Co., Ltd.) and the resulting material was heat-pressed at 5.2 MPa and 200°C for 15 minutes. After cooling to 100°C or less while applying pressure, the sample was removed to obtain a both-side copper clad laminate, with the crosslinked resin adhering to the surface.

The cross-cut adhesion test according JIS K5400 of the surface resin layer to the inner side copper foil was carried out to confirm that no peeling was observed.

### INDUSTRIAL APPLICABILITY

A cyclic olefin thermoplastic resin composition exhibiting excellent storage stability and excellent fluidity during heating and lamination is provided by the present invention.

A thermoplastic resin composition film can be obtained by molding the thermoplastic resin composition of the present invention in the shape of a film. A thermoplastic resin composition-impregnated prepreg can be obtained by impregnating a fiber material with the thermoplastic resin composition.

Since the cyclic olefin thermoplastic resin which constitutes the thermoplastic resin composition of the present invention is excellent in electric insulation characteristics, mechanical characteristics, dielectric properties, and interlayer adhesion, the composition is useful as a raw material for producing electricity and electronic industry materials such as a metal clad laminate and a printed-wiring board.

A process for efficiently producing the thermoplastic resin composition of the present invention is also provided by the present invention.

A crosslinked resin with excellent productivity produced by crosslinking the thermoplastic resin composition of the present invention is further provided by the present invention.

A crosslinked resin composite material prepared by laminating the thermoplastic resin composition of the present invention on a substrate and crosslinking the thermoplastic resin is also provided. The cross linked resin composite material of the present invention has excellent adhesion of the crosslinked resin and a substrate.

## Claims

1. A polymerizable composition which comprises (i) a cycloolefin monomer, (ii) a metathesis polymerization catalyst, (iii) a chain transfer agent, (iv) a radical crosslinking agent, and (v) a compound (α) selected from the group consisting of compounds having an alkoxyphenol structure with one or more substituents on the aromatic ring, compounds having an aryloxyphenol structure, and compounds having a catechol structure with two or more substituents on the aromatic ring.

2. The polymerizable composition according to Claim 1, wherein the compound (α) is a retarder for radical crosslinking.

3. The polymerizable composition according to Claim 1, wherein the compound (α) is a compound having an alkoxyphenol structure with one or more substituents on the aromatic ring.

4. The polymerizable composition according to Claim 1, wherein the content of the radical crosslinking agent is 0.1-10 parts by weight per 100 parts by weight of the cycloolefin monomer and the content of the compound (α) is 0.001-1 mol per one mol of the radical crosslinking agent.

5. A thermoplastic resin composition comprising (1) a cycloolefin thermoplastic resin, (2) a radical crosslinking agent, and (3) a compound (α) selected from the group consisting of compounds having an alkoxyphenol structure with one or more substituents on the aromatic ring, compounds having an aryloxyphenol structure, and compounds having a catechol structure with two or more substituents on the aromatic ring.

6. The thermoplastic resin composition according to Claim 5, wherein the compound (α) is a retarder for radical crosslinking.

7. The thermoplastic resin composition according to Claim 5, wherein the compound (α) is a compound having an alkoxyphenol structure with one or more substituents on the aromatic ring.

8. The thermoplastic resin composition according to Claim 5, wherein the content of the radical crosslinking agent is 0.1-10 parts by weight per 100 parts by weight of the cycloolefin thermoplastic resin and the content of the compound (α) is 0.001-1 mol per one mol of the radical crosslinking agent.

9. The thermoplastic resin composition according to Claim 5 in the form of a film.

10. The thermoplastic resin composition according to Claim 5 impregnated in a fiber material.

11. A process for producing the thermoplastic resin composition of Claim 5, comprising a step of polymerizing the polymerizable composition of Claim 1 by bulk polymerization.

12. The process according to Claim 11, wherein the bulk polymerization is carried out at a temperature equivalent to or lower than the one-minute half-life temperature of the radical crosslinking agent.

13. The process according to Claim 11, comprising the step of polymerizing the polymerizable composition of Claim 1 by bulk polymerization on a supporting body and molding the polymer into the form of a film.

14. The process according to Claim 13, wherein the supporting body is a resin film or a metallic foil.

15. A crosslinked resin prepared by crosslinking the thermoplastic resin composition of Claim 5.

16. A process for producing a crosslinked resin comprising a step of crosslinking the thermoplastic resin composition of Claim 5 by heating to melt at a temperature of 150-250°C.

17. A crosslinked resin composite material produced by laminating a substrate with the thermoplastic resin composition of Claim 5 and crosslinking the thermoplastic resin composition.

18. The crosslinked resin composite material according to Claim 17, wherein the substrate is a metallic foil.

19. The crosslinked resin composite material according to Claim 17, wherein the substrate is a printed-wiring board.
